(19) Europäisches Patentamt
European Patent Office
Office européen des brevets

(11) Publication number: **0 143 963 B1**

(12) # EUROPEAN PATENT SPECIFICATION

(45) Date of publication of patent specification: **22.07.92**

(51) Int. Cl.[5]: **H01L 21/312**, H01L 21/76, H01L 23/52

(21) Application number: **84112628.7**

(22) Date of filing: **19.10.84**

(54) **Electronic components comprising cured vinyl and/or acetylene terminated copolymers and methods for forming the same.**

(30) Priority: **30.11.83 US 556734**

(43) Date of publication of application:
**12.06.85 Bulletin 85/24**

(45) Publication of the grant of the patent:
**22.07.92 Bulletin 92/30**

(84) Designated Contracting States:
**DE FR GB**

(56) References cited:
**EP-A- 144 661**
**EP-A- 0 019 391**
**EP-A- 0 144 661**
**GB-A- 2 107 926**

(73) Proprietor: **International Business Machines Corporation**
**Old Orchard Road**
**Armonk, N.Y. 10504(US)**

(72) Inventor: **Araps, Constance Joan**
**Route 376 and Myers Corner Road**
**Wappingers Falls New York 12590(US)**
Inventor: **Kandetzke, Steven Michael**
**5-8 Loudon Drive**
**Fishkill New York 12524(US)**
Inventor: **Takacs, Mark Anthony**
**10A Stuart Drive**
**Poughkeepsie New York 12603(US)**

(74) Representative: **Kreidler, Eva-Maria, Dr. rer. nat.**
**Schönaicher Strasse 220**
**W-7030 Böblingen(DE)**



Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method for forming polyimide dielectrically isolated island regions in a semiconductor substrate and a semiconductor substrate containing said island regions thereof separated by a trench pattern as defined in the claims.

There is a significant interest in the semiconductor industry in replacing traditional inorganic dielectric materials with polymeric materials as device deep dielectric isolation, often termed trenches in the art. Polymeric materials are less expensive, can be more easily purified and fabricated, and potentially have better thermal and electrical characteristics than some inorganic counterparts.

In the monolithic integrated circuit technology, it is usually necessary to isolate various active and passive elements from one another in the integrated circuit structure. These devices have been isolated by back biasing, PN junctions, partial dielectric isolation and complete dielectric isolation. The dielectric materials used have been silicon dioxide, glass or polymers.

The preferred isolation for such active devices and circuits is some form of dielectric isolation because it permits the circuit elements and or corresponding elements to be adjacent the isolation and thereby result in greater density of packing of the active and passive devices on the integrated circuit chip.

It is also known that recessed dielectric isolation can be produced by first selectively removing silicon from a substrate so as to form trenches in the substrate and then filling the trenches with a dielectric material.

In the interest of minimizing the silicon chip area occupied by the dielectrically filled trenches, sputter etching processes and reactive ion etching processes have been utilized to form the trenches in the silicon substrate.

U. S. patents 3,766,438; 3,961,355; 4,104,086; 4,139,442; and 4,160,991 disclose various electronic devices involving the use of dielectric isolation. The dielectric isolation of the present invention can be used in forming devices as taught in these references. In detail, U. S. patent 3,766,438 discloses a planar dielectrically isolated semiconductor structure which comprises a plurality of isolated islands of semiconductor material separated from one another by isolation channel regions of dielectric material. The surface layer of the channel regions contiguous to the islands is composed of a dielectric material deposited at a different time than the bulk of the regions of dielectric material. A planar surface dielectric layer covers the entire surface of the structure to fully isolate the islands, and the contiguous layer extends into the surface dielectric layer at corners in the isolation channel regions.

U. S. patent 3,961,355 relates to a semiconductor device having a heavily doped epitaxial layer overlying the surface of the substrate and of the same conductivity type as the substrate. Electrically insulating barriers extend from the surface of the epitaxial layer into the substrate so as to electrically isolate areas of each surface leakage sensitive device within the epitaxial layer from areas of adjacent surface leakage sensitive devices.

U. S. patent 4,104,086 relates to a method for isolating regions of silicon which comprises forming openings that have a suitable taper in a block of silicon, thermally oxidizing the surfaces of the openings, and filling the openings with a dielectric material to isolate regions of silicon within the silicon block. The openings are preferably made through a region of silicon having a layer of a high doping conductivity.

U. S. patent 4,139,442 relates to a method for producing deeply recessed oxidized regions in silicon. Deep trenches are formed in a silicon wafer by reactive ion etching (RIE). In a first species, trenches are of equal width. A block-off mask is selectively employed during part of the RIE process to produce trenches of unequal depth. All trenches are filled by thermal oxidation. In a second species, trenches are of equal depth and width and of uniform spacing. Trenches are filled by thermal oxidation and, if necessary, by the deposition of a suitable material.

U. S patent 4,160,991 relates to a method for manufacturing a high performance bipolar device and the resulting structure with a very small emitter-base spacing. In this method a silicon semiconductor body is provided having regions of monocrystalline silicon isolated from one another by isolation regions and a burried subcollector therein. The base region, emitter and collector reach-through regions, and a doped polycrystalline silicon making ohmic contact to the base region are formed. The emitter junction is formed in the base region. Electrical contacts to emitter and collector are made.

U. s. patent 4,030,948 discloses the use of polyimide containing silicones which are deposited in a moat or groove 114 employed to control leakage across the end portions of PM junction 102. The dielectric material of the present invention can be substituted for the polyimide containing silicones in this patent.

U. S. patent 4,333,794 discloses in Fig. 14 a polyimide isolation as represented by numeral 66 formed by applying a conventional polyimide material such as Monsanto Skybond and then etching back in $O_2$ plasma at room temperature. Mechanical stresses near the side wall are stated to be reduced, the

polyimides are stated to have excellent planarization capability and to boost device performance since they have a lower dielectric constant than $SiO_2$.

UK patent application 2 107 926 A relates to a semiconductor device and method of manufacture. According to this reference regions of semiconductor material are laterally separated from adjacent regions by grooves. An insulating layer is then formed on the surface of the semiconductor material including the surfaces of the grooves. A polyimide material is formed over the top surface of the insulating layer and the grooves to fill said grooves and to provide a smooth top surface over the structure.

The grooves are made by anisotropic wet etching with KOH and have a depth of approximately 1.0 to 1.5 µm. The insulating layer consists of silicon oxide or nitride. The polyimide is a conventional material, for example PIQ 13 sold by Hitachi, and is applied in a layer thickness of approximately 1.5 to 4.0 µm.

U. S. patent 4,353,778 discloses a method of etching openings in a polyimide film which can be used in an electronic device. The polyimide material is applied as polyamic acid and then partially cured and, following processing steps, the polyimide is again cured to crosslink the same so that it will resist attack by a strong base.

The European patent application 0019391 discloses a method for manufacturing electronic devices having a multilayer wiring structure using a polyimide dielectric material between the layers. The polyimide dielectric material is a thermosetting addition polymerization type polyimide which possesses imide rings in recurring units and a degree of polymerization which increases when cured due to the radical reaction of the end group or groups thereof. The thermosetting addition polymerization type polyimide possesses a molecular weight range from approximately 800 to approximately 20,000, preferably from approximately 1,000 to approximately 10,000. The uncured polyimide is precured by heating at approximately 220 °C, and completely cured by heating at approximately 350 °C (page 3, lines 2; 10). The materials of the present invention differ in that they have a narrower range of molecular weights and superior properties which are directly attributable to the polymerizable oligomers and the range of molecular weights later described. Furthermore, the materials are cured at temperatures different from those disclosed in European patent application 0019391.

U. S. patents 3,700,497; 3,946,166; 3,486,934; 3,515,585; 3,985,597; and 4,367,119 disclose polyimides, polyimide-polyamides or like materials used as insulating or passivating materials in electronic components.

U. S. patent 3,700,497 relates to a method of making a semiconductor device which includes using a masking film composed of a thermoplastic type polyimide resin.

U. S. patent 3,846,166 relates to a method of producing a multilayer wiring structure for an integrated circuit wherein resin layers are employed as insulating layers between conductor layers. Any resin material having properties required for accomplishing the process of the invention, such as polyimide resins, can be used.

U. S. patent 3,985,597 relates to a process for forming an embedded interconnection metallurgy system on a substrate wherein a layer of a polyimide plastic material is applied to the substrate, and the desired metallurgy pattern is made by using a multi-layered lift-off structure.

U. S. patent 4,367,119 provides a technique for building a planar multi-level metal-insulator structure. A dual composite mask for a lift-off multi-layered structure process is used in which a base component layer acts as an etch stop for the reactive ion etching of the overlying layers. The process is an improvement to the lift-off method described in U. S. patent 3,985,597.

None of the materials disclosed in the above references are equivalent to those of the present invention.

Object of the invention is a method for forming dielectrically isolated island regions in a semiconductor substrate.

The electronic devices comprising polyimides suitable for dielectric isolation and with improved processability are also included.

The object of the invention is achieved by a method comprising:

(A) forming in said substrate a recessed trench pattern defining a plurality of isolated island regions;

(B) filling said trenches with a composition containing as a component a polymerizable oligomer selected from the group consisting of polyamic acid, the corresponding amic ester, the corresponding amic isoimide, the corresponding imide and mixtures thereof, wherein said polymerizable oligomer exhibits a number average molecular weight ranging from 1,500 to 8,000, and wherein the end groups of said polymerizable oligomer are end-capped with a vinyl or acetylenic end group; and

(C) thermally curing the composition in situ in the trenches at temperatures up to 500 °C to form an imidized polyimide therein.

The present invention provides an electronic component comprising a three-dimensional cured product of a vinyl or acetylene terminated polyamic acid, the corresponding amic ester, the corresponding isoimide, the corresponding imide, analogues thereof and mixtures thereof, wherein the polymerizable oligomer exhibits a number average molecular weight ranging from 1,500 to 8,000. Hereafter such materials are often

merely referred to generically as "oligomers" for brevity and the cured three-dimensional reaction product thereof is often merely referred to as a "cured polyimide" for brevity.

Major objects of the present invention are to provide dielectric and/or passivating materials for use in electronic component fabrication which are formed from oligomeric materials which have high solubility in conventional process solvents to provide a coating solution of excellent wetting and planarizing properties and which can be used, for example, to provide device deep dielectric isolation and which can be cured to provide a polyimide which is free of voids, bubbles, cracks, blistering, delamination or excess shrinkage, which cured polyimide exhibits excellent adhesion, thermal stability, electrical properties and chemical resistance.

The major advantage of the polymerizable oligomers of the present invention and the resulting cured polyimide of the present invention is that the polymerizable oligomers of the present invention essentially can be used to fill a device deep dielectric isolation or trench in a manner similar to a monomer (providing excellent wetting, filling and planarizing capability) but can be totally cured or reacted to provide a high molecular weight cured polyimide which exhibits properties quite dissimilar from the polymerizable oligomer which are most suited for device deep dielectric isolation.

The main criterion which the oligomers of the present invention illustrate is that they are substituted with reactive terminae, specifically, with vinyl and/or acetylene groups, which permits them to be thermally cured to yield a cross-linked three-dimensional dielectric material suitable for dielectric isolation, most especially deep device dielectric isolation (hereafter often merely referred to as "trench isolation" for brevity).

One major advantage of the present invention is that since the cured polyimide is not present in the form of a thin film, problems with stress resulting from high temperature curing (or cross-linking) are not encountered to the extent that such stress problems are encountered with a thin film. Accordingly, per the present invention the simpler and less expensive thermal cure can be used.

Although the cured polyimides of the present invention find particular application as a trench filling material, the cured polyimides of the present invention can be used in any application where dielectric isolation and/or passivation is required in an electric component, for example, as a replacement for the ceramic layers in a multilayer ceramic module, see, for example, SOLID STATE TECHNOLOGY, May 1972, Vol. 15, No. 5, pages 35-40, Kaiser et al.

Major advantages of the oligomers of the present invention are later discussed. They are polyamic acid or polyamic esters that are end-capped or terminated with reactive functional groups and can be dissolved in common organic solvents to a very high solids content, e.g., as high as about 70 to 80 weight percent can be readily coated onto devices to fill trenches, and are easily planarized, that is, result in an extremely smooth, defect-free surface, and can then be thermally cured to provide a cross-linked three-dimensional network which results in a cured polyimide of high molecular weight and good thermal and chemical properties. This is opposed to conventional polyimides which cure to yield a two-dimensional network.

The polymerizable oligomers of the present invention include the polyamic acid, the corresponding amic ester, the corresponding isoimide, the corresponding imide and analogues thereof. They can be represented by the formulae later set out.

As can be seen from the formulae, the end groups of the polymerizable oligomers are end-capped with a vinyl or acetylenic end group.

They are available under the trade name Thermid® from the Natural Starch and Chemical Corp.

As obtained, they typically have a molecular weight on the order from about 600 ~ 1,000 to about 10,000, determined by GPC.

As one skilled in the art will appreciate, the molecular weights of the polymerizable oligomers of the present invention cannot be specified as a completely definite range since there is a variability in useful molecular weights depending upon the exact polymerizable oligomer selected, the solvent selected, the desire or non-desire to use multiple polymerizable oligomer applications, the desire or non-desire to have low solvent concentrations and like considerations as will be apparent to one skilled in the art. However, for most commercial process line operations, it is contemplated that useful polymerizable oligomers will have a number average molecular weight in the range of from about 1,500 to about 8,000 as determined by GPC (herein molecular weights are on the same basis unless otherwise indicated). Currently preferred polymerizable oligomers have a molecular weight of from about 2,000 to about 4,000.

FORMULA 1
POLY(AMIC ACID

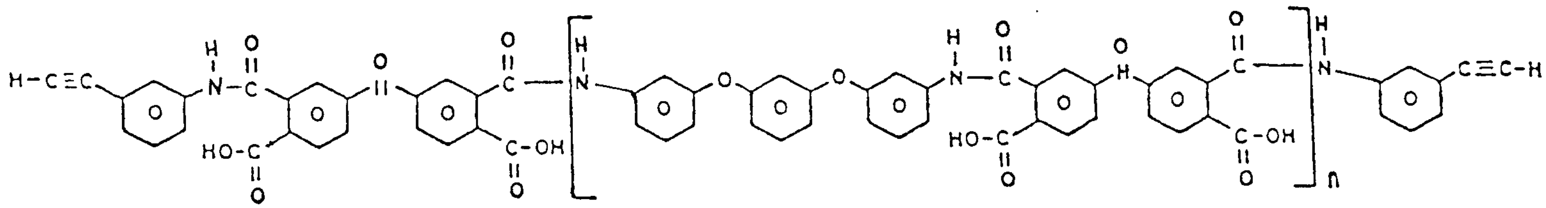

FORMULA 2
POLY (AMIC ESTER)

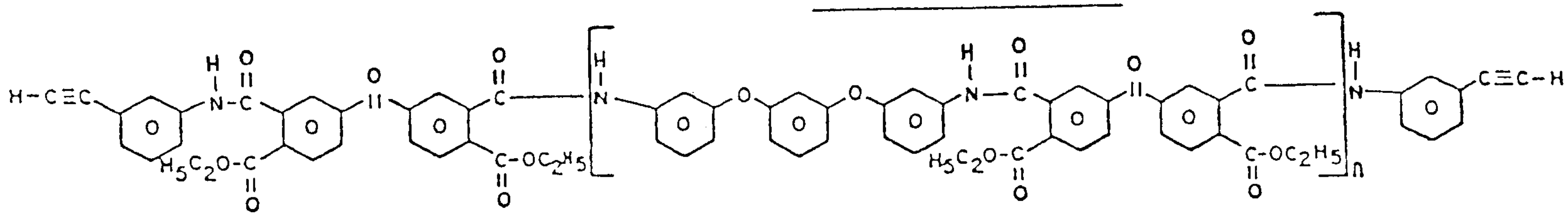

where n = 0 to about 50

FORMULA 3
POLY (ISOIMIDE)

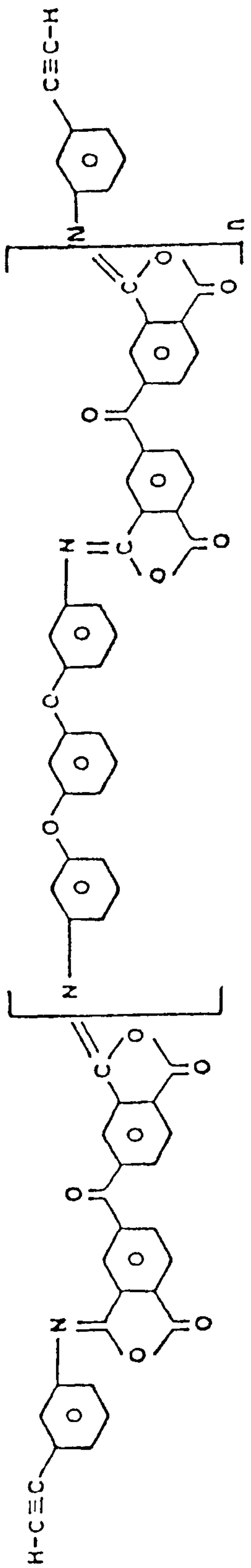

FORMULA 4
POLY (IMIDE)

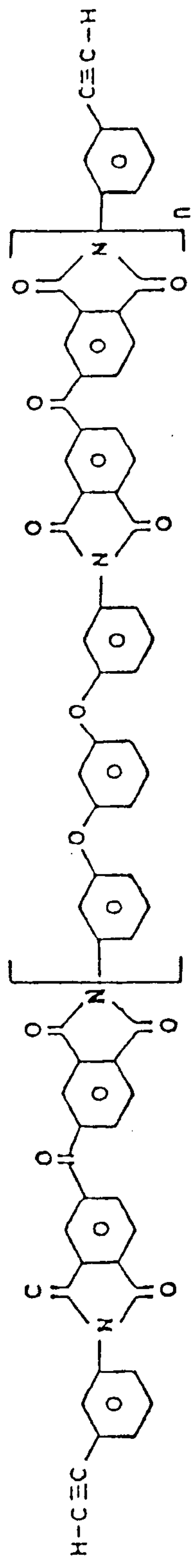

where n = 0 to about 50

The polymerizable oligomers of the present invention are soluble in common organic solvents, for example, alcohols, ketones, ethers, amides, etc., a typical exemplary solvent being N-methyl pyrrolidinone (NMP). Since they are substituted with reactive terminae they can be cured or crosslinked to yield the desired dielectric and/or passivation material *in situ* to provide a strong three-dimensional network which provides the desired cured polyimide of high molecular weight and good thermal and chemical properties

(as opposed to conventional polyimides which cure to yield a two-dimensional network).

Mixtures of solvents can be used if desired, but we currently see no benefit to using such mixtures unless oligomer as obtained from the vendor is in a solvent and more economical solvents are available. In such cases, a mixture of compatible solvents should be useful.

Where the oligomer is used as obtained from the vendor, the solvent content of the "as obtained" oligomer should be taken into account in determining the final amount of solvent needed for coating.

There are certain differences between the polyamic acid/ester, isoimide, imide, and analogue forms, and certain are preferred as now discussed.

As received, the Thermid® LR-600 amic acid (vendor information) of formula 1 has a molecular weight range of from about 600 to about 10,000. This material also contains a small amount of a gel fraction that appears on all GPC analysis as a high molecular weight fraction, e.g., on the order of 3,000,000. To obtain excellent wetting and film forming properties, it is most preferred that this commercial material be fractionated to remove the high molecular weight components, leaving a most preferred molecular weight fraction on the order of about 2,500 to about 3,000 (GPC analysis), with only traces of the gel fraction remaining.

Fractionation is performed in a conventional manner by dissolving the product as received in N-methyl pyrrolidinone (NMP), methyl isobutyl ketone and methyl alcohol, filtering the same through a one micron filter (which removes undissolved material having a molecular weight over about 4,000), precipitating the same in toluene to remove a low molecular weight fraction, collecting the solids, dissolving the solids in acetone, filtering the same through a one micron filter, reprecipitating into toluene, collecting the resulting solid and drying, whereafter the resulting product having a molecular weight of about 2,500 to about 3,000 is dissolved in NMP and passed through a one micron filter to prepare the desired coating solution.

Fractionation should also reduce the ionic content of the polyamic acid and remove unreacted monomers which might contaminate the resin and reduce its thermal stability.

The fractionated product can be dissolved in a variety of ketonic solvents, NMP, etc., and exhibits improved wetting and film forming properties as compared to the as received material, providing defect-free smooth films.

Other polymerizable oligomers as received from the vendor have a number average molecular weight range of from about 600 ~ 1,000 to about 10,000, as earlier indicated.

The isoimide of formula 3 as received (Thermid IP-600) is pre-cyclized from the amic acid of formula 1 during synthesis to yield the isomer of the imide form of formula 4. The isoimide of formula 3 is kinetically preferred but the imide of formula 4 is thermodynamically preferred as it is more stable and is, in any case, obtained upon heating either the amic acid of formula 1 or the isoimide of formula 3.

The polymerizable oligomers can be fully cured by heating at 0.5 hours at 200° C, 0.5 hours at 300° C and 4 hours at 400° C, with all curing above 85° C being done under nitrogen. A consistent low rate of weight loss of equal to or less than 0.12 wt%/hour was observed, an acceptable value. This curing cycle is not mandatory, nor critical, and other curing cycles are later provided.

It is also contemplated in accordance with the present invention that copolymers of the oligomers of the present invention will be useful. An example of such a copolymer would be the polymerization product of an acetylene terminated oligomer with triethynyl benzene. Such copolymers are expected to have a higher moduli due to the presence of polytriethynyl benzene regions and are expected to have higher thermal and hydrolytic stability. The reduction in imide content would also reduce the susceptability of the cured polyimide to absorb water and polar solvents.

The polymerizable oligomers of the present invention which are end-capped with a vinyl or acetylenic end group per the present invention, most preferably an acetylenic group, which have formula 3 (the isoimide) are preferred to the amic acid of formula 1 or the imide of formula 4 for the following reasons.

The isoimide has a high degree of solubility, comparable to the amic acid, and will form concentrated solutions suitable for spin coating in ketonic solvents as well as NMP. The ketonic solvents appear to improve wetting and film forming properties. The imide analogue, however, dissolves only in NMP.

The isoimide softens at about 160° C, well below the onset of gelation (190° C; 6 minutes) and this capacity to soften before cross-linking occurs should result in superior planarization and film uniformity. The imide and amic acid soften at above 190° C.

The isoimide rearranges thermally to yield a cross-linked imide without the evolution of water or alcohol. This is a substantial benefit since water is tenaciously bound in polyimides and is not completely removed until samples are heated at 350° C, or above, for a minimum of 30 minutes. Continuous outgassing of solvent (NMP) and water during cross-linking could result in undesirable porosity and pin-holes.

The molecular weight distribution of the isoimide as received (powder form) is about 2,000 - 4,000 (GPC analysis) with no trace of a high molecular weight gel fraction. Thus, as opposed to the amic acid as

received, Thermid® LR-600, no additional purification and/or fractionation need be conducted. At present, we believe that only the amic acid as received requires fractionation.

Upon heating (150-300 °C) the polymerizable oligomers of the present invention undergo three types of reactions: imidization via dehydration of the amic acid or elimination of alcohol from the amic ester functionalities and thermal rearrangement of the isoimide to yield the imide and radically induced addition reactions of the reactive terminal groups, be they vinyl or acetylinic end groups. The terminal end groups can add to other terminal end groups generating cross-links at chain ends or with carbonyl groups contained within the polyimide chain. These addition reactions deactivate the requisite reactive functional groups and generate the desired three-dimensional polymer network in the cured polyimide. As earlier noted, conventional linear polyimide resins undergo only imidization upon heating and result in a two-dimensional network.

As earlier indicated, the oligomers of the present invention can be used to form areas which are to serve as dielectric isolation/passivation regions in electronic components of diverse natures. However, the oligomers of the present invention, due to their excellent characteristics, which will later be discussed, find particular application in filling what have come to be known as deep dielectric isolation trenches. For example, such trenches typically have the following dimensions: 2 µm x 6 µm to 0.5 µm x 5.5 µm (width then depth). These dimensions are preferred.

One particular advantage is that the oligomers of the present invention can be used at high concentrations with a low solvent content. As indicated, oligomer concentrations up to about 70 ~ 80 weight percent or more, based on solution weight (hereinafter same basis unless otherwise indicated) can be used. We believe most typically oligomer concentrations on the order of about 30 weight percent to about 60 weight percent will be conveniently used on a commercial process line scale.

The starting oligomer solutions are formed in a simple manner; the oligomer is simply well mixed with the desired solvent to provide an oligomer solution of the desired proportions. Mixing is typically at ambient temperature, but there is no reason why lower or higher temperatures could not be used. Lower temperatures tend to increase solution viscosity and higher temperatures tend to increase solvent volatilization in some cases. Accordingly, we currently see no benefit to using conditions other than at ambient. Mixing can be performed using any conventional mixing device.

The oligomer-containing solution can be applied to the desired portion of the electronic component by any conventional means, for example, spin casting, spraying, meniscus coating, etc.

One major advantage of using the oligomers of the present invention is that they can be thermally cured.

Following curing, the oligomers result in a polymer having a three-dimensional network.

After the oligomer-containing solution of the present invention is applied, it can be dried followed by a separate curing step or, more preferably, we use a combined dry/cure cycle. The major benefit to a dry/cure cycle is that, of course, in one processing step we can effect both functions of drying and curing.

In those instances where a separate drying step is used, we normally prefer to use a temperature below the temperature at which any substantial degree of cross-linking occurs. We believe, however, that so long as excessive crosslinking does not occur such that solvent evaporization might harm the desired dielectric isolation, the initiation of curing during solvent drive-off will probably not be harmful. However, we normally prefer to drive off or purge solvent prior to the initation of any substantial degree of curing.

Typically, where a separate drying step is used this will be at a temperature less than about 100 °C for a time of from about 1/2 to about 2 hours, more generally about 1 hour.

We generally, however, prefer to use a combined dry/cure process, with thermal curing.

Further, we most prefer to use a stepped dry/cure processing, i.e., where the temperature of the curing polyimide is raised through various steps. By using a stepped dry/cure, at lower temperatures we effect solvent drive-off from the polymerizable oligomer/solvent system, whereafter at higher temperatures curing is effected. While a stepped dry/cure cycle is not mandatory, this avoids the possibility that solvent evaporation might harm the desired dielectric isolation. Typically solvent drive-off is at a temperature below about 100 °C. Times are as earlier given.

Thermal curing is then effected at a temperature of from about 200 °C to about 500 °C, more preferably from about 200 °C to about 400 °C. While not to be construed as limitative, thermal curing is usually completed in about 4 to 6 hours following the dry cycle of about 1/2 to about 2 hours, more typically in about 5-1/2 hours.

Thermal curing is typically in an inert atmosphere such as nitrogen, argon etc., but we believe the potentially air or a vacuum can be used, but we see no current benefit to using the same.

Following processing as above, the desired cured polyimide characterized by its three-dimensional network is obtained.

The polymerizable oligomers can be fully cured by heating at 0.5 hours at 200 ° C, 0.5 hours at 300 ° C and 4 hours at 400 ° C, with all curing above 85 ° C being done under nitrogen. An alternative cure cycle involves heating at 85 ° C for 30 minutes, 170 ° C for 1 hour, 200 ° C for 1 hour, 300 ° C for 1 hour (this step is optional)) and 400 ° C for 4 1/2 hours. The time between steps is unimportant and can be rapid. After completion of curing, the cooling rate is unimportant. One skilled in the art will easily appreciate that other curing cycles can be used with success, but we have found the above curing cycles to offer excellent results. A consistent low rate of weight loss of 0.12 weight%/hour or less was observed, an acceptable value.

Following curing, if it is desired or necessary to remove the cured polyimide of the present invention so as to planarize the surface thereof, this can be effected using a conventional reactive ion etching in a manner known in the art. Such is described in detail in "A Survey of Plasma-Etching Processes" by Richard L. Bersin, published in Solid State Technology, May 1976, pages 31-36 and "Reactive Ion Etching in Chlorinated Plasma" by Geraldine C. Schwartz et al, Solid State Technology, November 1980, pages 85-91, both hereby incorporated by reference. Following the procedure of these publications, the cured polyimide of the present invention can be uniformly etched back with no resultant residue.

Exemplifying the above, the oligomers per the present invention can be readily cross-linked and imidized by heating and that their physical properties can be further improved as a result of morphological changes that occur at higher temperatures, e.g., up to 500 ° C.

Having thus generally described the oligomers of the present invention, solutions containing the same, means of applying the same and means of curing the same to obtain the desired cured polyimide, we now turn to a detailed discussion of the superior properties of the cured polyimide of the present invention, which are primarily relevant from a device aspect, and to a discussion of the superior properties of the oligomers of the present invention, which are primarily of interest from the processing aspect since in the final device, of course, only the cured polyimide is present.

The cured polyimide contains essentially no voids, bubbles, non-wet areas and exhibits no cracking or crazing in common process solvents.

The cured polyimide can be uniformly etched back with no resultant residue.

The cured polyimide exhibits excellent adhesion to various surfaces including metals and inorganic components as are typically used in semiconductor devices, e.g., silicon, alumina and silicon nitride. Adhesion is so good that films of the cured polyimide could not be peeled off from silicon nitride even in the absence of an adhesion promoter. A comparable commercially available cured polyimide (Dupont 5878, trade name) shows this type of adhesion only in the presence of an adhesion promoter. While if desired an adhesion promoter can be used in accordance with the present invention, it is one substantial benefit of the present invention that an adhesion promoter is not necessary.

The coefficient of thermal expansion of the cured polyimide is $25.42 \times 10^{-6}$ per degree C which is compatible with the coefficient of thermal expansion of silicon, alumina and silicon nitride and is comparable to that of convention polyimides.

Since the cured polyimide in the trench will remain as a device isolation dielectric, it must be thermally stable and remain substantially unaltered during personalization processing and total chip lifetime. Thermal cycling to temperatures as high as 500 ° C can be involved while the material is contained in a bed of inorganic dielectrics. Long-term stability to such thermal cycling conditions is required for chip reliability.

The cured polyimide is thermally stable to 400 ° C, exhibits negligible outgassing after 10 hours at 400 ° C, no adhesion loss and no morphological changes. It is believed that the negligible outgassing is due to the presence of interchain crosslinks and although bond scission occurs as a result of heating, fewer volatile groups appear to be generated due to the presence of the cross-links.

The cured polyimide has excellent electrical properties, e.g., its dielectric constant does not change after exposure to water or thermal cycling and it is resistant to polarization and charge inversion. Due to the higher hydrocarbon content of the cured polyimide and higher degree of cross-linking as compared to conventional polyimides, it is significantly more hydrophobic than conventional polyimides. For example, after exposure to 96 % humidity for 1,000 hours the cured polyimide contains less than 1 % water and exhibit no change in dielectric constant. The commercially available polyimide Kapton, in comparison, absorbs ~ 2.9 % water under comparable conditions and shows a dielectric constant increased 11 % over normal.

The increased hydrophobic nature of the cured polyimide also provides the cured polyimide with a minimal tendency to absorb process solvents, thereby reducing its tendency to swell or crack when exposed to, e.g., polar process solvents. This tendency to reduced swelling is a critical factor for trench isolation and is one of the most important variables in forming a successful trench isolation. Further, it is believed that the high degree of cross-linking in the cured polyimide of the present invention interferes with

the crack propagation mechanism.

High temperature annealing is generally required to obtain optimum properties with conventional polyimides and this is also the case with the cured polyimides of the present invention. High temperature annealing is in accordance with the conditions used in the prior art for conventional polyimides.

Finally, the assembled three-dimensional network resulting from the radical coupling and addition reactions of the oligomer terminae is significantly more resistant to deformation and cracking than is the two-dimensional conventional polyimide structure, in particular, the cured polyimides of the present invention exhibit a high modulus and tensile strength. More specifically, the cured polyimides of the present invention do not exhibit cracking under thermal stressing and solvent stressing, when used to fill a trench, during post-curing processing.

The oligomers of the present invention also exhibit highly desirable characteristics for use in forming dielectric and/or passivation elements in electronic components, though these properties are primarily from the process viewpoint as opposed to the final device viewpoint.

Because of their low molecular weight, solutions of high solids content, e.g., 40-60 %, can be prepared that are sufficiently fluid to trench fill and planarize with a single application using simple techniques which result in less solvent content and significantly less shrinkage and stress due to volume contraction upon solvent evaporation. In contrast, solutions of high molecular weight polyimides such as D-5878 (available from du Pont) cannot be used in concentrated solution form due to the prohibitively high viscosity of the resulting solution. Typically usable solutions comprise about 12-15 % of such a polyimide and result in voids, delamination and excessive shrinkage when used in trench fill applications.

Because of the low molecular weight of the oligomers, they dissolve in organic alcohols, ketones, ethers, amides, etc., resulting in solutions which readily wet a variety of surfaces, e.g., silicon nitride, ceramic surfaces, silicon dioxide, etc.

Although high molecular weight is desirable in the cured polyimide of the present invention, it is undesirable in the oligomer of the present invention. Increasing the molecular weight increases the viscosity of the oligomer solution at constant mass, and results in solutions with poor levelling and wetting properties. For example, a solution of 45 % of the polyamic acid oligomer of the present invention has a viscosity of 0.3 Pa•s whereas a 40 % solution of a commercially available polyamic acid (Dupont 5878, trade name) has a viscosity of 50-80 Pa•s.

Having thus generally described the invention, the following working example(s) is/are provided to illustrate currently preferred modes of practicing the same.

## EXAMPLE 1

As earlier indicated, the polymerizable oligomers of the present invention are essentially used as a replacement for dielectric isolation in conventional semiconductor devices and the like.

In this particular instance, a conventional trenched silicon wafer was used, trench dimensions being 2.0 µm (width) x 5.5 µm (depth). The polymerizable oligomer selected was Thermid® IP-600, the isoimide. It was received in powder form from the vendor and had a molecular weight of from about 2,000 to about 4,000.

It was mixed with NMP at ambient temperature to provide an isoimide solution containing 37 % by weight isoimide based on solution weight.

It was then spin coated in a conventional manner on a trenched wafer as above described.

Following application, the polymerizable oligomer solution was subjected to a combined dry/cure cycle at the following conditions in an inert atmosphere (nitrogen) in a conventional heating furnace.

The time of temperature elevation was not important and was merely the time necessary to raise the atmosphere in the dry/cure furnace used from one temperature to the next. The times and temperatures were (starting at ambient): at 85 °C for 10 minutes; at 170 °C for one-half hour; at 200 °C for one-half hour; at 300 °C for one-half hour; at 400 °C for four and one-half hours.

Following processing as above, the trenched wafer was removed from the furnace and permitted to cool in the air at ambient conditions.

Conditions of cooling are not important; of course, the cooling rate should not be so fast that any device component would crack or the like, but this will be apparent to one skilled in the art.

Following cooling, the surface of the device was oxygen plasma RIE etched in a standard conventional diode device.

The dielectric isolation obtained exhibited the benefits earlier described.

Fractionated amic acid was also used with excellent results as a trench fill material. Solutions in NMP were spun onto trenched structures and step-wise heated to 400 °C to effect full cure. The resulting devices

had trenches with no voids or "dewets" and excellent local planarization, i.e., equal to or greater than 95 %. Analysis after plasma etch back established that the reactive ion etching was uniform and did not result in any residues.

Trench filling with the isoimide showed excellent local trench planarization with thin (1.3 µm) application. Material flow occurs at 160 °C prior to cross-linking permitting excellent levelling and subsequent plasma etch back produces a planar trench structure. Since we normally use a conventional RIE "etch back" after curing, usually the complete top of the wafer is coated with the polymerizable oligomer solution, e.g., 0.5 ~ 5 µm dry thickness.

## Claims

**1.** Method for forming dielectrically isolated island regions in a semiconductor substrate comprising:
(A) forming in said substrate a recessed trench pattern defining a plurality of isolated island regions;
(B) filling said trenches with a composition containing as a component a polymerizable oligomer selected from the group consisting of polyamic acid, the corresponding amic ester, the corresponding isoimide, the corresponding imide and mixtures thereof, wherein said polymerizable oligomer exhibits a number average molecular weight ranging from 1,500 to 8,000, and wherein the end groups of said polymerizable oligomer are end-capped with a vinyl or acetylenic end group; and
(C) thermally curing the composition in situ in the trenches at temperatures up to 500 °C to form an imidized polyimide therein.

**2.** Method of claim 1 including forming an integrated circuit in the island regions.

**3.** Method of claim 1 wherein said polymerizable oligomer is comprised of polyisoimide.

**4.** Method of claims 1 and 3 wherein the end groups of said polymerizable oligomer are end-capped with an acetylenic group.

**5.** Method of claims 1, 3 and 4 wherein said polymerizable oligomer exhibits a number average molecular weight ranging from 2,000 to 4,000, preferably from 2,500 to 3,000.

**6.** Method of one or several of claims 1 to 5 wherein said polyisoimide concentration ranges from 30 to 60 weight percent.

**7.** Method of one or several of claims 1 to 6 wherein said recessed trenches range in width from 0.5 µm to 2 µm, and range in depth from 5.5 to 6 µm.

**8.** Method of claim 1 wherein said thermal curing is accomplished using a combined dry/cure cycle in an inert atmosphere.

**9.** Method of claims 1 and 8 wherein said cure cycle is initiated at 85 °C, and stepped to 170 °C, followed by 200 °C, followed by 300 °C, and a final curing step at 400 °C.

**10.** Method of claims 1, and 7 to 9 wherein post curing the composition in the trenches in situ at 500 °C is included.

**11.** Method of one or several of claims 1 to 10 wherein the composition includes triethynyl benzene to be copolymerized with said polymerizable oligomer.

**12.** Semiconductor substrate containing isolated island regions thereof separated by a trench pattern containing in situ cured polyimide obtained by thermally curing at temperatures up to 500 °C a composition comprising a polymerizable oligomer selected from the group consisting of polyamic acid, the corresponding amic ester, the corresponding isoimide, the corresponding imide and mixtures thereof, wherein said polymerizable oligomer exhibits a number average molecular weight ranging from 1,500 to 8,000, and wherein the end groups of said polymerizable oligomer are end-capped with a vinyl or acetylenic end group.

## Revendications

1. Procédé pour former des régions d'îlots isolées diélectriquement dans un substrat semiconducteur, comprenant:
(A) la formation dans ce substrat d'un motif de rainures en retrait définissant plusieurs régions d'îlots isolées;
(B) le remplissage de ces rainures avec une composition contenant en tant qu'un composant, un oligomère polymérisable choisi dans le groupe consistant en acide polyamique, l'ester amique correspondant, l'isoimide correspondant, l'imide correspondant et leurs mélanges, cet oligomère polymérisable ayant un poids moléculaire moyen en nombre de l'ordre de 1.500 à 8.000 et les groupes terminaux de cet oligomère polymérisable étant coiffés avec un groupe terminal vinyle ou acétylénique; et
(C) le durcissement thermique de la composition in situ dans les rainures à des températures allant jusqu'à 500 °C pour former un polyimide imidé dans celles-ci.

2. Procédé suivant la revendication 1 incluant la formation d'un circuit intégré dans les régions d'îlots.

3. Procédé suivant la revendication 1 dans lequel cet oligomère polymérisable est composé de polyisoimide.

4. Procédé suivant les revendications 1 et 3, dans lequel les groupes terminaux de cet oligomère polymérisable sont coiffés par un groupe acétylénique.

5. Procédé suivant les revendications 1, 3 et 4, dans lequel cet oligomère polymérisable présente un poids moléculaire moyen en nombre de l'ordre de 2.000 à 4.000, de préférence de 2.500 à 3.000.

6. Procédé suivant l'une ou plusieurs des revendications 1 à 5, dans lequel cette concentration en polyisoimide est de l'ordre de 30 à 60% en poids.

7. Procédé suivant l'une ou plusieurs des revendications 1 à 6, dans lequel ces rainures en retrait ont une largeur de l'ordre de 0,5 à 2 µm et une profondeur de l'ordre de 5,5 à 6 µm.

8. Procédé suivant la revendication 1, dans lequel ce durcissement thermique est accompli au moyen d'un cycle de séchage/durcissement combinés dans une atmosphère inerte.

9. Procédé suivant les revendications 1 et 8, dans lequel ce cycle de durcissement débute à 85 °C, comprend une étape à 170 °C, puis à 200 °C, puis à 300 °C et une étape finale de durcissement à 400 °C.

10. Procédé suivant les revendications 1 et 7 à 9, incluant un post-durcissement de la composition dans les rainures in situ à 500 °C.

11. Procédé suivant l'une ou plusieurs des revendications 1 à 10, dans lequel la composition comprend du triéthynyl benzène à copolymériser avec cet oligomère polymérisable.

12. Substrat semiconducteur contenant des régions d'îlots isolées de celui-ci séparées par un motif de rainures contenant un polyimide durci in situ obtenu par durcissement thermique à des températures allant jusqu'à 500 °C d'une composition comprenant un oligomère polymériable choisi dans le groupe consistant en acide polyamique, l'ester amique correspondant, l'isoimide correspondant, l'imide correspondant et leurs mélanges, cet oligomère polymérisable ayant un poids moléculaire moyen en nombre de l'ordre de 1.500 à 8.000 et les groupes terminaux de cet oligomère polymérisable étant coiffés parun groupe terminal vinyle ou acétylénique

**Patentansprüche**

1. Verfahren zur Herstellung dielektrisch isolierter Bereiche in einem Halbleitersubstrat, welches folgende Schritte umfaßt:
(A) Ausbilden eines abgesenkten Grabenmusters in besagtem Substrat, wobei das Grabenmuster eine Vielzahl isolierter Bereiche definiert;

(B) Auffüllen besagter Gräben mit einer Zusammensetzung, welche als einen Bestandteil ein polymerisierbares Oligomer aus der Gruppe von Polyamidocarbonsäure, dem entsprechenden Amidocarbonsäureester, dem entsprechenden Isoimid, dem entsprechenden Imid und Mischungen derselben umfaßt, wobei besagtes polymerisierbares Oligomer ein mittleres Molekulargewicht nach der Zahl im Bereich von 1.500 bis 8.000 aufweist, und die Endgruppen des besagten polymerisierbaren Oligomeren mit einer Vinyl- oder Acetylenendgruppe verschlossen sind; und

(C) Thermisches in situ Härten der Zusammensetzung in den Gräben bei Temperaturen bis zu 500 °C unter Ausbildung eines Imidgruppen haltigen Polyimids in denselben.

**2.** Verfahren nach Anspruch 1, bei dem in den isolierten Bereichen eine integrierte Schaltung ausgebildet ist.

**3.** Verfahren nach Anspruch 1, bei dem das polymerisierbare Oligomer Polyisoimid umfaßt.

**4.** Verfahren nach den Ansprüchen 1 und 3, bei dem die Endgruppen des polymerisierbaren Oligomeren mit einer Acetylenendgruppe verschlossen sind.

**5.** Verfahren nach den Ansprüchen 1, 3 und 4, bei dem das polymerisierbare Oligomer ein mittleres Molekulargewicht nach der Zahl im Bereich von 2,000 bis 4,000, bevorzugt im Bereich von 2,500 bis 3,000 aufweist.

**6.** Verfahren nach einem oder mehreren der Ansprüche 1 bis 5, bei dem die Polyisoimidkonzentration im Bereich von 30 bis 60 Gewichtsprozent liegt.

**7.** Verfahren nach einem oder mehreren der Ansprüche 1 bis 6, bei dem besagte abgesenkte Gräben eine Weite von 0,5 µm bis 2 µm und eine Tiefe von 5,5 bis 6 µm aufweisen.

**8.** Verfahren nach Anspruch 1, bei dem besagte thermische Härtung in Form eines kombinierten Trocknungs- und Härtungszyklus in einer inerten Atmosphäre durchgeführt wird.

**9.** Verfahren nach den Ansprüchen 1 und 8, bei dem besagter Härtungszyklus bei 85 °C anfängt, stufenweise auf 170 °C angehoben wird, gefolgt von 200 °C, gefolgt von 300 °C, and einer Endhärtung bei 400 °C.

**10.** Verfahren nach den Ansprüchen 1, und 7 bis 9, welches eine in situ Nachhärtung der Zusammensetzung in den Gräben bei 500 °C einschließt.

**11.** Verfahren nach einem oder mehreren der Ansprüche 1 bis 10, bei dem die Zusammensetzung Triethynylbenzol enthält, welches mit besagtem polymerisierbarem Oligomer ein Copolymer bildet.

**12.** Halbleitersubstrat, welches isolierte Bereiche enthält, die durch ein Grabenmuster voneinander getrennt sind, das seinerseits in situ gehärtetes Polyimid enthält, das durch thermische Härtung bei Temperaturen bis zu 500 °C einer Zusammensetzung aus einem polymersierbaren Oligomer aus der Gruppe von Polyamidocarbonsäure, dem entsprechenden Amidocarbonsäureester, dem entsprechenden Isoimid, dem entsprechenden Imid und Mischungen derselben erhalten wird, wobei besagtes polymerisierbares Oligomer ein mittleres Molekulargewicht nach der Zahl im Bereich von 1,500 bis 8,000 aufweist und die Endgruppen des besagten polymerisierbaren Oligomeren mit einer Vinyl- oder Acetylenendgruppe verschlossen sind.